# EUROPEAN PATENT APPLICATION

(11) **EP 4 492 522 A1**
(43) Date of publication of application: **15.01.2025**
(21) Application number: 24777203.1
(22) Date of filing: 25.01.2024
(51) Int. Cl.: H01M 10/04, H01M 50/296

(54) **AUTOMATIC SEPARATION JIG FOR MANUFACTURING BATTERY MODULE**

(30) Priority: 16.05.2023 KR 20230063155
(71) Applicant: LG Energy Solution Ltd., 07335 Seoul (KR)
(72) Inventor: PARK, Sungkyu, Daejeon 34122 (KR)
(74) Representative: Goddar, Heinz J.
(86) International application number: PCT/KR2024/001203
(87) International publication number: WO 2024/237425

(57) **Abstract**

An automatic separation jig for manufacturing a battery module includes a button lever and a guide holder to which the button lever is coupled and which is configured to guide a movement of the button lever. A connector of the battery module coupled to a connector of an inspection board is separated by operating the button lever.

## Description

### TECHNICAL FIELD

The present disclosure relates to an automatic separation jig for manufacturing a battery module, and more specifically, to a jig capable of automatically disconnecting the connection between a connector of a sensing electrical component of a battery module and an inspection board with one touch in a battery module manufacturing process.

### BACKGROUND

A secondary battery means a battery capable of charging/discharging, unlike a non-rechargeable primary battery, and is applied not only to portable devices but also to electric vehicles (EV, Electric Vehicle) and hybrid vehicles (HEV, Hybrid Electric Vehicle) that are driven by an electric drive source.

Currently, widely used secondary batteries include lithium ion batteries, lithium polymer batteries, nickel-cadmium batteries, nickel-hydrogen batteries, nickel-zinc batteries, and the like. The operating voltage of a unit secondary battery cell, i.e., a unit battery cell, is about 2.5V-4.2V. Accordingly, when higher output voltage is required, a plurality of battery cells may be connected in series to construct a battery pack. Additionally, according to the charge/discharge capacity required for the battery pack, a plurality of battery cells may be connected in parallel to construct a battery pack. Accordingly, the number of battery cells included in the battery pack may be variously set according to the required output voltage or charge/discharge capacity.

When constructing a battery pack by connecting a plurality of battery cells in series/in parallel, it is common to first construct a battery module including at least one battery cell, preferably a plurality of battery cells, and then construct a battery pack using at least one such battery module with the addition of other components. Herein, the battery module refers to a component in which a plurality of battery cells are connected in series or in parallel, and the battery pack refers to a component in which a plurality of battery modules are connected in series or in parallel to increase the capacity and output.

The battery module is configured with electrical components (FPCB, ICB) for sensing voltage, temperature, etc. In order to inspect a product in a battery module manufacturing process, it is necessary to assemble a connector of a sensing electrical component and an inspection board of production line equipment.

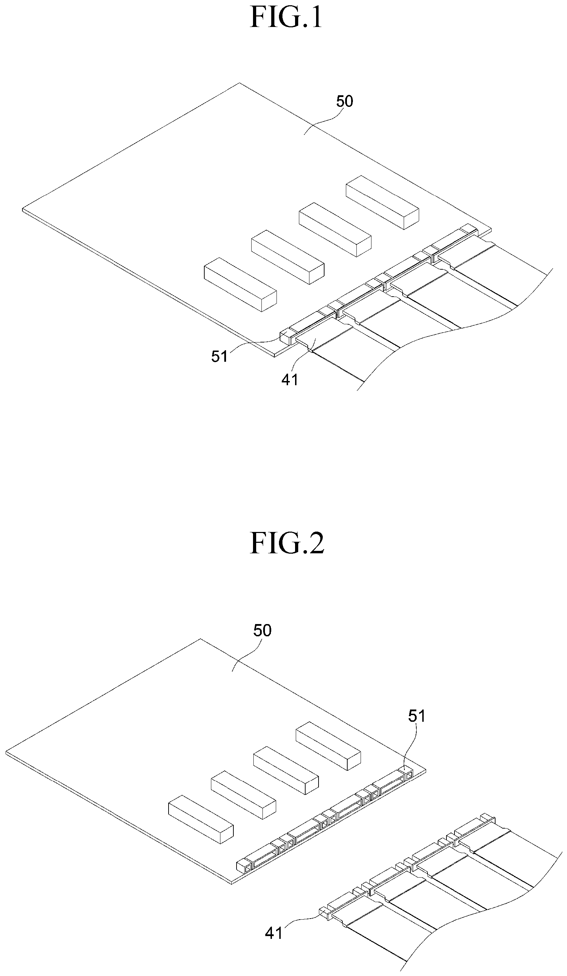

FIG. 1 is a diagram illustrating a state in which the connector of the sensing electrical component and the inspection board are connected in an existing battery module. FIG. 2 is a diagram illustrating a state in which the connector of the sensing electrical component and the inspection board in FIG. 1 are separated.

As illustrated, the connector of the sensing electrical component in the existing battery module is configured with a hook structure to prevent the connector from being separated due to vibration or impact in the field, or is configured with a device that is not easily loosened in such a way that the connector is press-fitted.

Accordingly, in a production line, after the final EOL inspection of a product, it is difficult to disassemble the connector of the sensing electrical component from a connector 51 of an inspection board. Issues arise due to the narrow space between the inspection board and the connector of the product, difficult connector disassembly work, and damage to physically weak electrical components.

### TECHNICAL PROBLEM

An aspect of the present disclosure is directed to providing an automatic separation jig for a battery module capable of eliminating a source cause of defects during connector disassembly work in an inspection process for manufacturing a battery module, reducing production loss and cost by improving workability, and addressing safety issues caused by damage to electrical components of high-voltage products.

### TECHNICAL SOLUTION

An automatic separation jig for manufacturing a battery module according to an aspect of the present disclosure includes: a button lever; and a guide holder to which the button lever is coupled and to guide a movement of the button lever, wherein a connector of the battery module coupled to a connector of an inspection board is separated by operating the button lever.

In addition, a plurality of the button levers are spaced apart and disposed on the guide holder.

In addition, the button lever includes a button unit; and a slide unit movably disposed on the guide holder.

In addition, the slide unit extends in one direction from one side of the button unit.

In addition, the slide unit is formed integrally with the button unit.

In addition, the slide unit includes a connector pressing rib for pressing the connector of the battery module.

In addition, the slide unit includes a hook pressing unit for pressing a hook of the connector of the battery module.

In addition, the guide holder includes an insertion hole into which the slide unit is inserted and guides a movement of the slide unit.

In addition, the plurality of the button levers are spaced apart and disposed on the guide holder, and the insertion hole is formed in a plural number so that each of the slide units is inserted into the insertion hole.

In addition, the insertion hole is formed from one side surface of the guide holder to the other side surface opposite to the guide holder.

In addition, the insertion hole has an inclined surface that is inclined downward at the bottom so that the slide unit moves forward and downward when sliding.

In addition, the guide holder further includes an insertion groove on one side surface where the button unit is disposed.

In addition, the insertion groove communicates with one end of the insertion hole.

In addition, the automatic separation jig for manufacturing the battery module is disposed on the inspection board.

In addition, a lower groove is formed in a lower portion of the guide holder, and the connector of the inspection board is located in the lower groove.

In addition, the connector of the battery module is preferably a connector of a sensing unit in the battery module.

### ADVANTAGEOUS EFFECTS

Accordingly, according to an aspect of the present disclosure, a connector can be disassembled with a one-touch method even in a narrow space when a battery module is manufactured, thereby preventing losses and risks due to damage to electrical components.

In addition, according to an aspect of the present disclosure, the connector of the battery module can be separated from the connector of the inspection board at once in a one-touch manner.

### BRIEF DESCRIPTION OF THE DRAWINGS

FIG. 1 is a diagram illustrating a state in which a connector of a sensing electrical component of the existing battery module and an inspection board are connected.
FIG. 2 is a diagram illustrating a state in which the connector of the sensing electrical component of a battery module and the inspection board in FIG. 1 are separated.
FIG. 3 is a perspective view of the battery module.
FIG. 4 is an exploded perspective view of the battery module of FIG. 3.
FIG. 5 is a partial detailed view of a cell top frame in FIG. 3.
FIG. 6 is a perspective view of an automatic separation jig according to an aspect of the present disclosure.
FIG. 7 is a perspective view of a button lever in FIG. 6.
FIG. 8 is a bottom perspective view of the button lever illustrated in FIG. 7.
FIG. 9 is a diagram illustrating a state in which the automatic separation jig according to an aspect of the present disclosure is seated on the inspection board.
FIG. 10 is a cross-sectional view showing a state in which the connector of a sensing unit is connected to the inspection board while the automatic separation jig according to an aspect of the present disclosure is seated on the inspection board.
FIG. 11 is a cross-sectional view showing a state in which the connector of the sensing unit is separated from the inspection board by the automatic separation jig according to an aspect of the present disclosure.
FIG. 12 is a perspective view showing a state in which the connector of the sensing unit has been completely separated from the inspection board.
FIG. 13 is a perspective view of an automatic separation jig according to another of the present disclosure.
FIG. 14 is a perspective view of the button lever in FIG. 13.
FIG. 15 is a cross-sectional view showing a state in which the connector of the sensing unit is connected to the inspection board while the automatic separation jig illustrated in FIG. 13 is seated on the inspection board.

### DETAILED DESCRIPTION

The advantages, features of the present disclosure, and methods for achieving the same will become apparent from the following description of aspects given in detail in conjunction with the accompanying drawings. However, the present disclosure is not limited to the aspects described herein but may be embodied in many different forms. Rather, the aspects disclosed herein are provided in order to ensure that the disclosure becomes thorough and perfect and to ensure that the scope of the present disclosure is sufficiently delivered to those skilled in the technical field to which the present disclosure pertains. The present disclosure is defined only by the claims. Accordingly, in some aspects, well-known process stages, well-known device structures, and well-known techniques are not specifically described in order to avoid ambiguous interpretation of the present disclosure. Like reference numerals refer to like elements throughout the specification.

In the drawings, in order to clearly express a plurality of layers and regions, the thickness may be exaggerated. Like reference numerals refer to like portions throughout the specification. It will be understood that when an element such as a layer, film, region or substrate is referred to as being "on" another element, it may be directly on the other element or intervening elements may also be present. In contrast, when an element is referred to as being "directly on" another element, there are no intervening elements present. Further, it will also be understood that when an element such as a layer, film, region or substrate is referred to as being "below" another element, it may be directly below the other element, or intervening elements may also be present. In contrast, when an element is referred to as being "directly below" another element, there are no intervening elements present.

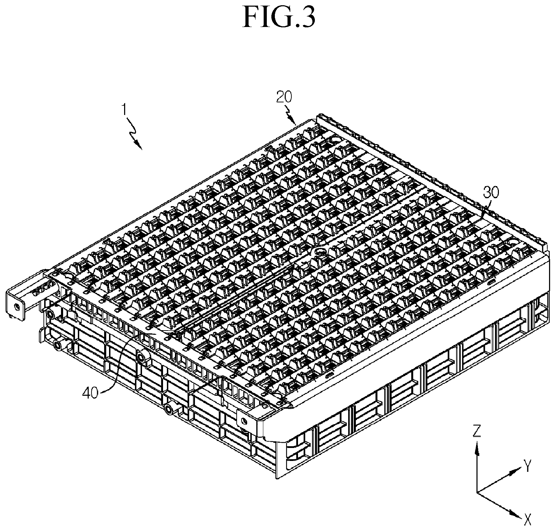

Prior to the description of an automatic separation jig 1000 for manufacturing a battery module according to an aspect of the present disclosure, the structure of a battery module 1 will be described with reference to FIGS. 3 to 5 as follows.

The battery module 1 may include a plurality of battery cells 10, a module housing 20, and a plurality of busbars 30, and may further include a sensing unit 40 connected to the bus bar 30 and used to sense the voltage and temperature of each cell.

The battery cells 10 may be cylindrical battery cells 10 in which an electrode assembly is embedded in a metal can. The cylindrical battery cell 10 may be configured to include a battery can 11 mainly made of a lightweight conductive metal material such as aluminum in a cylindrical shape, a jelly-roll type electrode assembly accommodated in the battery can 11, and a top cap coupled to an upper portion of the battery can 11. The top cap is connected to the positive electrode tab of the electrode assembly to function as a positive electrode terminal, and the battery can 11 is connected to the negative electrode tab of the electrode assembly to function as a negative electrode terminal.

The cylindrical battery cell 10 may be inserted and disposed in the module housing 20, and the cylindrical battery cells 10 are bonded to the busbars 30 by wire in a predetermined pattern to be connected in series and/or in parallel to each other.

The battery cells applied to the battery module 1 are not necessarily limited to the cylindrical battery cell 10. For example, the battery module 1 according to an aspect of the present disclosure may be configured using a can-type battery cell having a rectangular parallelepiped shape or other shape, other than a cylindrical shape in the battery can 11.

The module housing 20 is a structure for accommodating and fixing the battery cells 10 therein to protect the battery cells 10 from external impact or vibration, and may be configured to include a cell bottom frame 22 and a cell top frame 21.

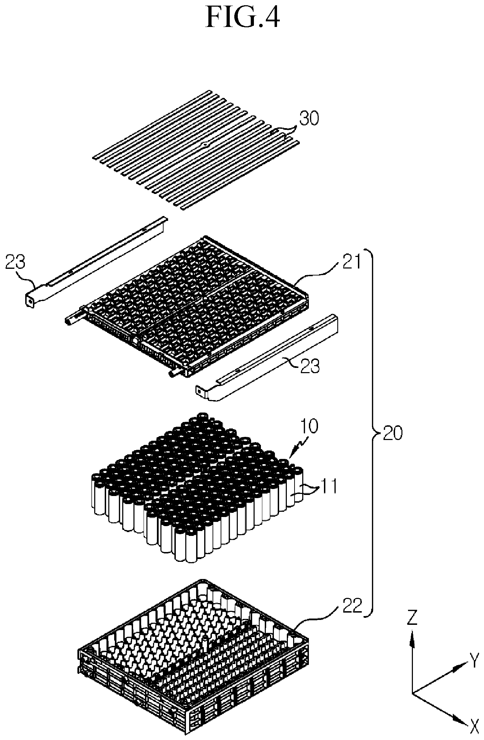

The cell bottom frame 22 may be configured to have cell insertion holes inside an outer rim in a rectangular box shape and to insert the battery cells 10 into the cell insertion holes one by one. For example, as shown in FIG. 4, the battery cells 10 may be inserted and disposed in each cell insertion hole such that the top cap faces upward and the lower region, that is, the bottom of the battery can 11 faces downward. Herein, the cell insertion hole is configured to penetrate the bottom surface of the cell bottom frame 22. Accordingly, the bottom of the battery can 11 of the battery cells 10 may be exposed below the bottom surface of the cell bottom frame 22. Although not illustrated in the drawings, it may also be configured such that a thermally conductive pad having insulation is attached to the bottom surface of the cell bottom frame 22 and a cooling plate or a heat sink (including a refrigerant therein) is attached to the other surface of the thermally conductive pad, thereby absorbing heat of the cylindrical battery cells 10.

The cell bottom frame 22 may be firmly coupled to the cell top frame 21 by a long bolt (not shown) together with hook fastening.

The cell top frame 21 may cover an upper region of the battery cells 10 and may be configured to be coupled to the cell bottom frame 22.

For example, the cell top frame 21 may have cell sockets (not shown) matching the cell insertion holes of the cell bottom frame 22 up and down. When the cell top frame 21 and the cell bottom frame 22 are coupled, the battery cells 10 may be introduced into the cell sockets from the top cap so that an upper region of the entire battery cells 10 may be covered by the cell top frame 21.

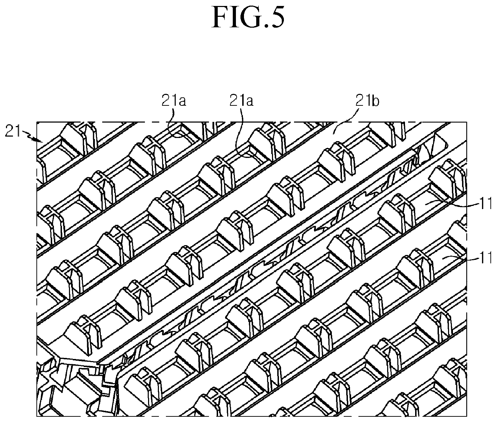

In addition, the cell top frame 21 may include an upper surface portion covering the top of the entire battery cells 10 and four side portions forming a wall surrounding the outside of the entire battery cells 10 together with the cell bottom frame 22, wherein the upper surface portion of the cell top frame 21, as illustrated in FIG. 5, has a plurality of holes 21a and seating grooves 21b. A side surface plate 23 may be coupled to a side surface portion of the cell top frame 21.

The holes 21a have a configuration in which the cell top frame 21 is partially perforated so that the top cap of the battery cells 10 or an upper end of the battery can 11 is partially exposed to the outside.

As illustrated in FIG. 4, the cell bottom frame 22, when the battery cells 10 are inserted therein, may be configured such that the battery cells 10 form a plurality of rows in an X-axis or Y-axis direction of the module housing 20. When such battery cells 10 are covered with the cell top frame 21, the top cap of each battery cell 10 or an upper end of the battery can 11 is partially exposed to the outside.

The holes 21a are used as paths for connecting the battery cells 10 located inside the module housing 20 to the busbars 30 located outside the module housing 20 by metal wires 500. For example, the bus bar 30 may be connected to the top cap exposed through the holes 21a or an upper end of the battery can 11 by a metal wire. For example, a wire bonding method in which one end of the metal wire is ultrasonically welded to the top cap or an upper end of the battery can 11 and the other end of the metal wire is ultrasonically welded to the bus bar 30 may be employed.

The seating grooves 21b are places where the bus bar 30 is to be seated and fixed, and may extend along the lengthwise direction (Y-axis direction) of the module housing 20 to be provided at predetermined intervals in the widthwise direction (X-axis direction) of the module housing 20. The bus bar 30, which is a straight metal conductor having the same left and right widths, may be disposed in each of the seating grooves 21b.

The bus bar 30 has approximately the same left and right widths as the seating groove 21b, so that its movement in the widthwise direction (X-axis direction) may be blocked.

In addition, the bus bar 30 may be provided in the form of a pin or a pillar formed to protrude from the surface of the seating groove 21b (in an Z-axis direction), and may have a pin hole disposed into which the pin of the seating groove 21b is inserted into the bus bar 30. Accordingly, the pin of the seating groove 21b is inserted into the pin hole of the bus bar 30, thereby preventing movement thereof.

In the battery module 1, the sensing unit 40 is an electrical component for sensing voltage, temperature, etc., and may include a sensing plate.

In order to inspect products in a battery module manufacturing process, it is necessary to assemble the connector 41 of the sensing electrical component and the inspection board 50 of production line equipment. The connector 41 of the sensing electrical component is configured with a hook structure to prevent the connector 41 from being separated due to vibration or impact in the field, or is configured with a device that is not easily loosened in such a way that the connector 41 is press-fitted.

Accordingly, in a production line, after the final EOL inspection of a product, it is difficult to disassemble the connector 41 of the sensing electrical component from a connector 51 of an inspection board 50. Issues arise due to the narrow space between the inspection board 50 and the connector 41 of the product, difficult connector disassembly work, and damage to physically weak electrical components.

In order to address an issue associated therewith, an aspect of the present disclosure is directed to providing an automatic separation jig 1000 for manufacturing the battery module to address an issue arising from connector release work, which is essential for EOL function inspection in the battery module manufacturing process.

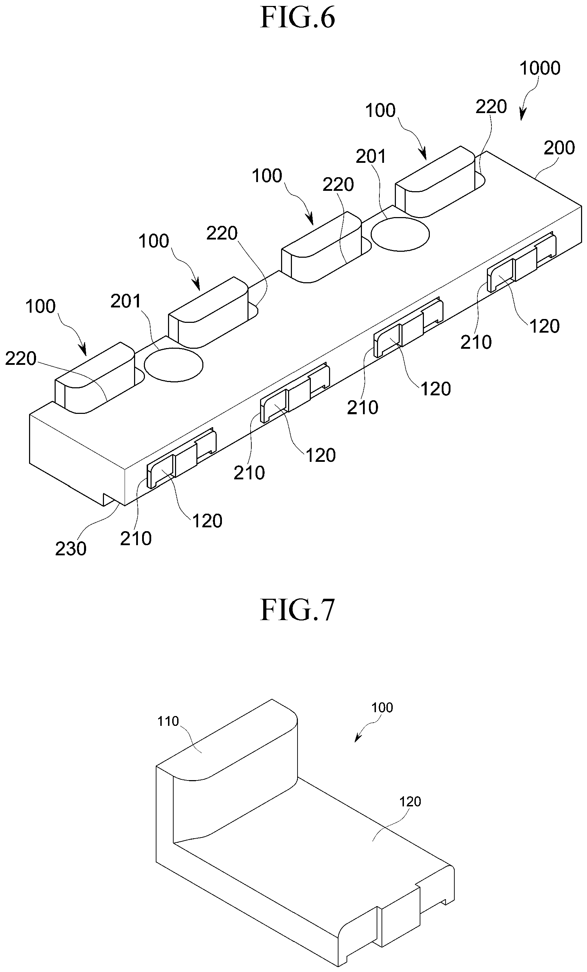

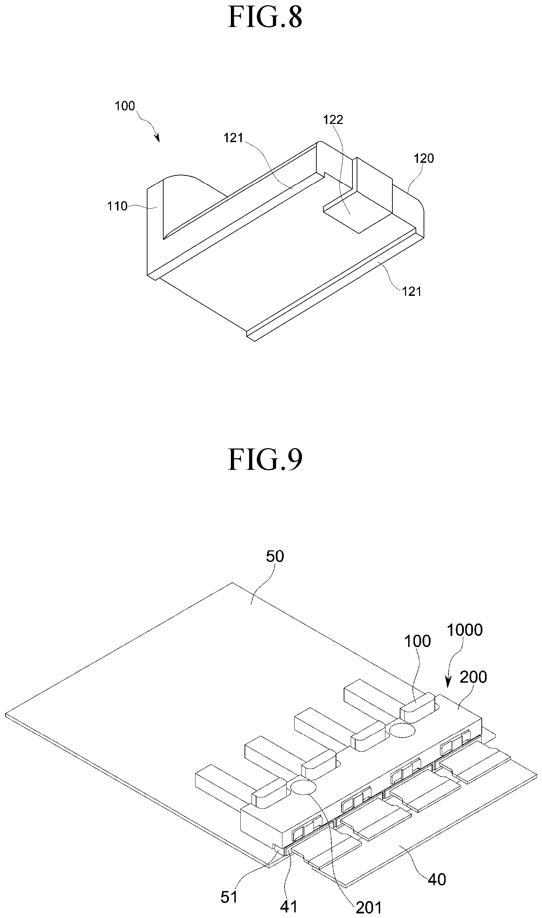

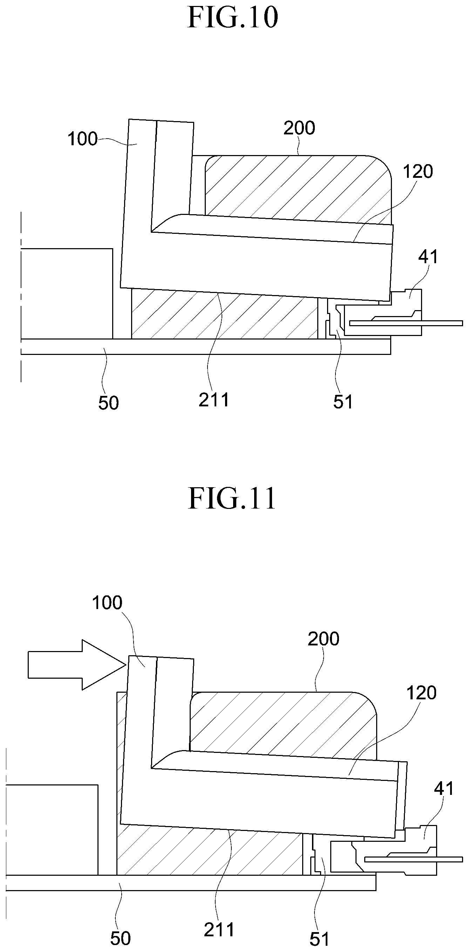

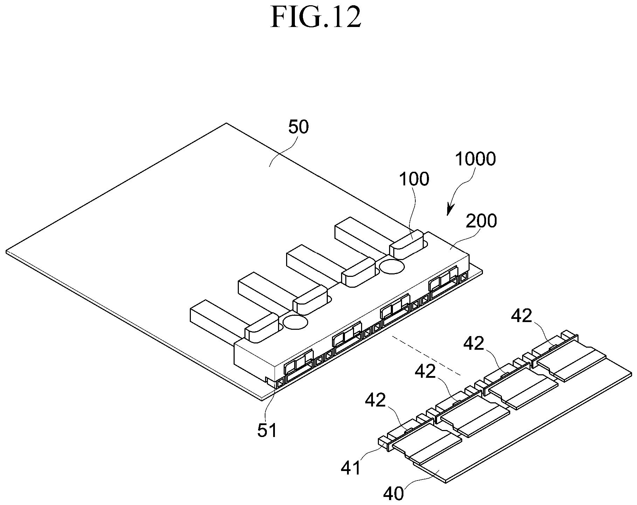

FIG. 6 is a perspective view of an automatic separation jig according to an aspect of the present disclosure. FIG. 7 is a perspective view of a button lever in FIG. 6. FIG. 8 is a bottom perspective view of the button lever illustrated in FIG. 7. FIG. 9 is a diagram illustrating a state in which the automatic separation jig according to an aspect of the present disclosure is seated on the inspection board. FIG. 10 is a cross-sectional view showing a state in which the connector of a sensing unit is connected to the inspection board while the automatic separation jig according to an aspect of the present disclosure is seated on the inspection board. FIG. 11 is a cross-sectional view showing a state in which the connector of the sensing unit is separated from the inspection board by the automatic separation jig according to an aspect of the present disclosure. FIG. 12 is a perspective view showing a state in which the connector of the sensing unit has been completely separated from the inspection board.

The automatic separation jig 1000 for manufacturing the battery module according to an aspect of the present disclosure may include a plurality of the button levers 100 and a guide holder 200 to which the button levers 100 are coupled.

The button lever 100 is a one-touch button lever 100 for separating the connector 41 of the sensing unit 40 from the inspection board 50 by one-touch operation, and may include a button unit 110 and a slide unit 120.

The button unit 110 is used to move the slide unit 120 to release the coupling of the connector 41. When a user presses the button unit 110 with his or her finger in the direction of the arrow as illustrated in FIG. 11, the slide unit 120 may move to release the coupling of the connector 41. The plurality of the button units 110 may each be located in an insertion groove 220 of the guide holder 200.

The slide unit 120 is used to release the coupling of the connector 41 from the inspection board 50 by manipulating the button unit 110. The slide unit 120 extends forward from a lower portion of the button unit 110, and is inserted into the insertion hole 210 of the guide holder 200. By manipulating the button unit 110, the slide unit 120 may slide into the insertion hole 210 to release the coupling of the connector 41.

The slide unit 120 may include a connector pressing rib 121 and a hook pressing unit 122.

As illustrated in FIG. 8, the connector pressing rib 121 protrudes downward on both sides of the lower surface of the slide unit 120 and extends along the lengthwise direction. The slide unit 120 may serve to press the connector 41 when sliding within the insertion hole 210 of the guide holder 200.

As illustrated in FIG. 8, the hook pressing unit 122 protrudes downward from the front of the lower surface of the slide unit 120. The slide unit 120 may serve to press a hook 42 of the connector 41 when sliding within the insertion hole 210 of the guide holder 200.

The slide unit 120 may be formed integrally with the button unit 110.

The material of the button lever 100 may be made of synthetic resin in this aspect or may be made of other materials.

In this aspect, four button levers 100 are illustrated coupled to the guide holder 200, but the number of button levers 100 may be changed.

The guide holder 200 is coupled to the button lever 100 and guides the movement of the button lever 100 according to the manipulation of the button unit 110, and may include the insertion hole 210 into which the slide unit 120 of the button lever 100 is inserted and the insertion groove 220 into which the button unit 110 of the button lever 100 is located.

The insertion hole 210 of the guide holder 200 is a place where the slide unit 120 of the button lever 100 is inserted. Four insertion holes 210 may be formed to be spaced apart from each other in the lengthwise direction of the guide holder 200, equal to the number of button levers 100.

As illustrated, the insertion hole 210 may be formed to penetrate from one side of the guide holder 200 to the other side, and the slide unit 120 of the button lever 100 may be inserted into one end of the insertion hole 210 and the end of the slide unit 120 may protrude to the other end of the insertion hole 210.

Then, the slide unit 120 of the button lever 100 may be seated at the bottom of the insertion hole 210, and the insertion hole 210 that guides the movement of the slide unit 120 may be formed to be inclined downward in a forward direction of the slide unit 120 with respect to the bottom of the guide holder 200. The bottom of the insertion hole 210 may have an inclined surface 211.

Accordingly, when the button lever 100 moves forward inside the insertion hole 210, as illustrated in FIGS. 10 and 11, the slide unit 120 moves along the inclined surface 211 that is inclined downward so that the slide unit 120 may also gradually move downward while moving forward.

The insertion groove 220 of the guide holder 200 is a place where the button unit 110 of the button lever 100 is inserted. Four insertion grooves 220 may be formed to be spaced apart from each other in the lengthwise direction of the guide holder 200, equal to the number of button levers 100.

As illustrated, the insertion groove 220 may be formed to be concave inward on one side of the guide holder 200, and the insertion groove 220 may communicate with one end of the insertion hole 210.

Accordingly, the slide unit 120 of the button lever 100 may be inserted into the insertion hole 210 and the button unit 110 may be located within the insertion groove 220.

In addition, the guide holder 200 may have a fastening hole 201. As illustrated, the fastening hole 201 is formed to penetrate the top and bottom of the guide holder 200 and is for fixing the guide holder 200 with a fixing bolt (not shown). The fixing bolt may be inserted into the fastening hole 201 and the inserted fixing bolt may be fastened to the inspection board 50, so that the automatic separation jig 1000 may be fixed to the inspection board 50.

Next, a method of operating the automatic separation jig 1000 for manufacturing the battery module according to an aspect of the present disclosure having the configuration described above will be described.

First, the automatic separation jig 1000 for manufacturing the battery module according to an aspect of the present disclosure is disposed on the inspection board 50 of the production line equipment. Specifically, as illustrated in FIG. 9, the automatic separation jig 1000 may be disposed on the inspection board 50 so that the connector 51 of the inspection board 50 is located in the lower groove 230 formed in the lower portion of the automatic separation jig 1000, and the automatic separation jig 1000 may be fixed to the inspection board 50 by fastening the fixing bolt inserted inside the fastening hole 201 to the inspection board 50.

In addition, in order to inspect the battery module 1, the connector 41 of the sensing unit 40 in the battery module 1 may be coupled to the connector 51 of the inspection board 50. Specifically, the hook 42 of the connector 41 in the sensing unit 40 may be caught and fixed to the connector 51 of the inspection board 50. Simultaneously, as illustrated in FIG. 10, when the connector 41 of the sensing unit 40 is inserted into the connector 51 of the inspection board 50, the connector 41 of the sensing unit 40 pushes the button lever 100 so that the button lever 100 may be located in a correct position.

As such, after the final inspection is completed with the connector 41 of the sensing unit 40 connected to the connector 51 of the inspection board 50, each connector 41 of the sensing unit 40 may be separated from the connector 51 of the inspection board 50.

When the connector 41 of the sensing unit 40 and the connector 51 of the inspection board 50 are separated, in the automatic separation jig 1000, an operator may press the button unit 110 of the button lever 100 with his or her finger in the direction of the arrow illustrated in FIG. 11.

Then, the button lever 100 moves forward, and the slide unit 120 of the button lever 100 is guided to the insertion hole 210 of the guide holder 200 and moves forward. Then, the slide unit 120 may move forward and gradually move downward by moving along the inclined surface 211 inclined downward and configuring the bottom of the insertion hole 210.

As the slide unit 120 gradually moves downward, the hook pressing unit 122 formed on the lower surface of the slide unit 120 presses the hook 42 of the connector 41, thereby releasing the fixation of the connector 41 of the sensing unit 40 and the connector 51 of the inspection board 50. Then, as the slide unit 120 moves forward, the slide unit 120 pushes the connector 41 of the sensing unit 40, so that the connector of the sensing unit may be completely separated from the connector 51 of the inspection board 50.

FIG. 12 is a perspective view showing a state in which the connector of the sensing unit has been completely separated from the inspection board.

Accordingly, in an aspect of the present disclosure, when an operator presses the button unit 110 in a one-touch method as described above, the slide unit 120 of the button lever 100 presses the hook 42 of the connector 41, and the connector 41 is separated from the inspection board 50. Hence, it is possible to eliminate a source cause of defects during connector disassembly work in an inspection process for manufacturing a battery module, address safety issues caused by damage to electrical components, and reduce production loss and cost by improving workability.

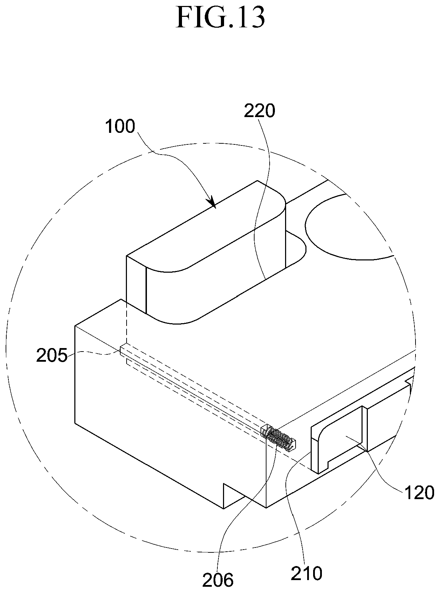

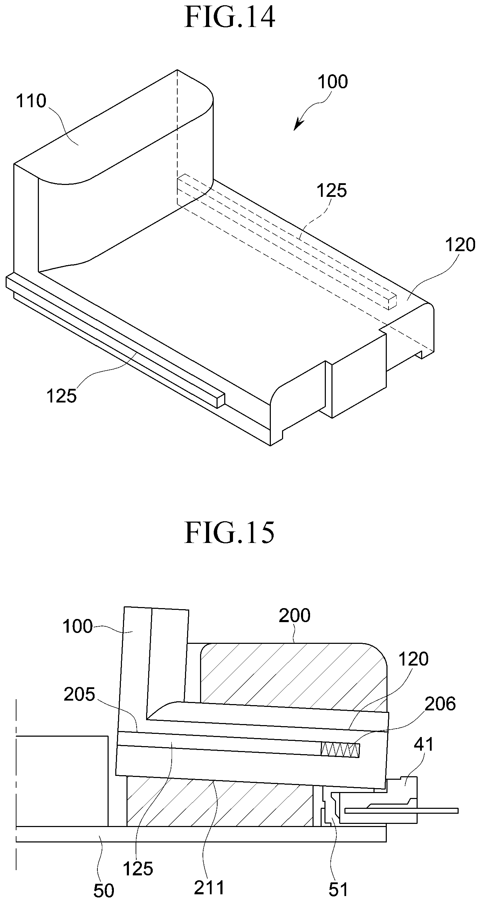

Next, the automatic separation jig according to a second aspect of the present disclosure will be described. FIG. 13 is a perspective view of an automatic separation jig according to another aspect of the present disclosure. FIG. 14 is a perspective view of the button lever in FIG. 13. FIG. 15 is a cross-sectional view showing a state in which the connector of the sensing unit is connected to the inspection board while the automatic separation jig illustrated in FIG. 13 is seated on the inspection board.

The automatic separation jig 1000 according to the second aspect of the present disclosure is different from that of the first aspect in that slide protrusions 125 are disposed on both side surfaces of the slide unit 120 of the button lever 100, and in the guide holder 200, guide grooves 205 into which the slide protrusions 125 are inserted are formed on both inner side surfaces of the insertion hole 210.

The guide groove 205 is used to guide the slide movement of the slide protrusions 125 in which the slide protrusions 125 of the slide unit 120 are inserted. Like the insertion hole 210 that is formed to be inclined downward in the forward direction of the slide unit 120, the guide groove 205 may also be formed to be inclined downward in the forward direction of the slide unit 120. Accordingly, the guide groove 205 may be formed parallel to the inclined surface 211 of the insertion hole 210. The guide grooves 205 may be formed on both side surfaces inside the insertion hole 210, respectively.

In addition, a spring 206 may be disposed in an inner front portion of the guide groove 205 to elastically support the slide protrusion 125 of the slide unit 120.

The spring 206 is used to elastically support the slide protrusion 125. As the slide unit 120 moves forward, the connector 41 of the sensing unit 40 is separated from the connector 51 of the inspection board 50. Then, the slide unit 120 may be returned to its original position by the restoring force of the spring 206.

The slide protrusions 125 may be disposed on both side surfaces of the slide unit 120, and each slide protrusion 125 may be inserted into the guide groove 205 inside the insertion hole 210 of the guide holder 200, so that the slide protrusions 125 may be guided and moved in the guide groove 205 as the slide unit 120 moves.

In the automatic separation jig 1000 according to the second aspect of the present disclosure, when the connector 41 of the sensing unit 40 and the connector 51 of the inspection board 50 are separated, as the button lever 100 moves forward, the slide unit 120 of the button lever 100 moves forward from the insertion hole 210 of the guide holder 200. Simultaneously, the slide protrusion 125 inserted into the guide groove 205 moves forward within the guide groove 205.

Then, the slide protrusion 125 moves along the downwardly inclined guide groove 205 so that the slide unit 120 may move forward and gradually move downward. Additionally, the slide protrusion 125 may compress the spring 206 while moving forward within the guide groove 205.

As the slide unit 120 gradually moves downward, the hook pressing unit 122 formed on the lower surface of the slide unit 120 presses the hook 42 of the connector 41, thereby releasing the fixation of the connector 41 of the sensing unit 40 and the connector 51 of the inspection board 50. Then, as the slide unit 120 moves forward, the slide unit 120 pushes the connector 41 of the sensing unit 40, so that the connector of the sensing unit may be completely separated from the connector 51 of the inspection board 50.

Then, when the pressing of the button unit 110 is released by an operator, the slide protrusion 125 returns to its original position by the restoring force of the compressed spring 206, and this allows the button lever 100 to return to its original position.

In the automatic separation jig 1000 according to the second aspect of the present disclosure, the slide protrusions 125 are disposed on both side surfaces of the slide unit 120 of the button lever 100, and the slide protrusions 125 are inserted into the guide groove 205 in the insertion hole 210 and moved. Thereby, the slide unit 120 is not twisted to the left or right, straightness is improved, and the separation work on of the connector 41 may be performed more stably.

Although the present disclosure has been described above with reference to preferred aspects, it is not limited to the aforementioned aspects. It will be understood by those skilled in the art to which the present disclosure pertains that various modifications and changes may be made to the present disclosure without departing from the spirit of the present disclosure.

### INDUSTRIAL APPLICABILITY

The present disclosure provides a jig capable of automatically disconnecting the connection between a connector of a sensing electrical component of a battery module and an inspection board with one touch in a battery module manufacturing process.

## Claims

1. An automatic separation jig for manufacturing a battery module, comprising:
a button lever; and
a guide holder configured to guide a movement of the button lever,
wherein the button lever is coupled to the guide holder, and
wherein a connector of the battery module coupled to a connector of an inspection board is separated by the button lever.

2. The automatic separation jig of claim 1, wherein a plurality of the button levers are spaced apart and disposed on the guide holder.

3. The automatic separation jig of claim 1, wherein the button lever comprises:
a button unit; and
a slide unit configured to be movably disposed on the guide holder.

4. The automatic separation jig of claim 3, wherein the slide unit extends in one direction from one side of the button unit.

5. The automatic separation jig of claim 3, wherein the slide unit is formed integrally with the button unit.

6. The automatic separation jig of claim 3, wherein the slide unit comprises a connector pressing rib configured to press the connector of the battery module.

7. The automatic separation jig of claim 3, wherein the slide unit comprises a hook pressing unit configured to press a hook of the connector of the battery module.

8. The automatic separation jig of claim 3, wherein the guide holder comprises an insertion hole into which the slide unit is inserted, and which is configured to guide a movement of the slide unit.

9. The automatic separation jig of claim 8, wherein:
a plurality of the button levers are spaced apart and disposed on the guide holder; and
the insertion hole is formed in a plural number so that each of the slide units is inserted into a respective insertion hole.

10. The automatic separation jig of claim 8, wherein the insertion hole is formed from one side surface of the guide holder to an opposite side surface of the guide holder.

11. The automatic separation jig of claim 8, wherein the insertion hole has an inclined surface that is inclined downward so that the slide unit is configured to move forward and downward when sliding.

12. The automatic separation jig of claim 8, wherein the guide holder further includes an insertion groove on one side surface where the button unit is disposed.

13. The automatic separation jig of claim 12, wherein the insertion groove communicates with one end of the insertion hole.

14. The automatic separation jig of claim 1, wherein the automatic separation jig is disposed on the inspection board.

15. The automatic separation jig of claim 1, wherein:
the guide holder comprises a lower groove in a lower portion thereof; and
the connector of the inspection board is located in the lower groove.

16. The automatic separation jig of claim 1, wherein the connector of the battery module is a connector of a sensing unit in the battery module.

17. The automatic separation jig of claim 3, wherein:
the button lever further comprises a slide protrusion disposed on the slide unit; and
the guide holder comprises a guide groove into which the slide protrusion is inserted and which is configured to guide a movement of the slide protrusion.

18. The automatic separation jig of claim 17, wherein the guide holder further comprises a spring disposed in the guide groove so as to elastically support the slide protrusion.

19. The automatic separation jig of claim 17, wherein the guide groove is formed to be inclined downward in a forward direction of the slide unit.

20. The automatic separation jig of claim 17, wherein:
the guide holder further comprises an insertion hole into which the slide unit is inserted and which is configured to guide a movement of the slide unit; and
the guide groove is disposed in the insertion hole.
